# EUROPÄISCHE PATENTSCHRIFT

(11) **EP 3 216 049 B1**
(45) Veröffentlichungstag und Bekanntmachung des Hinweises auf die Patenterteilung: **16.06.2021**
(21) Anmeldenummer: 14795815.1
(22) Anmeldetag: 05.11.2014
(51) Int. Cl.: H01L 21/67

(54) **VERFAHREN UND VORRICHTUNG ZUM BESCHICHTEN EINES PRODUKTSUBSTRATS**
METHOD AND DEVICE FOR COATING A PRODUCT SUBSTRATE
PROCÉDÉ ET DISPOSITIF DE REVÊTEMENT D'UN SUBSTRAT DE PRODUIT

(43) Veröffentlichungstag der Anmeldung: 13.09.2017
(73) Patentinhaber: EV Group E. Thallner GmbH, 4782 St. Florian (AT)
(72) Erfinder: THANNER, Christine, 84378 Dietersburg (DE)
(74) Vertreter: Schneider, Sascha
(86) Internationale Anmeldenummer: PCT/EP2014/073828
(87) Internationale Veröffentlichungsnummer: WO 2016/070915

(56) Entgegenhaltungen:
- EP-A1- 2 642 838
- JP-A- H1 051 108
- US-A1- 2008 164 592
- US-A1- 2009 186 450

## Beschreibung

Die Erfindung betrifft ein Verfahren gemäß Anspruch 1 und eine Vorrichtung gemäß Anspruch 6 zum Beschichten eines Produktsubstrats.

In der Halbleiterindustrie existieren verschieden Methoden, um sehr dünne Schichten, insbesondere Schichten mit mittleren Dicken im Mikro- oder sogar Nanometerbereich auf Oberflächen aufzubringen. Häufig werden direkte Beschichtungsverfahren angewendet, die ein Material an einer Oberfläche abscheiden. Dazu zählen beispielsweise chemische und physikalische Gasphasenabscheidung, Tauchverfahren etc. Diese direkten Beschichtungsverfahren beschichten im Allgemeinen immer die gesamte Oberfläche.

Druckschrift EP 2 642 838 A1 offenbart ein Verfahren zur Herstellung von Leiterplatten.

In der Halbleiterindustrie gibt es allerdings unzählige Verfahren, bei denen gerade nicht die gesamte Oberfläche beschichtet werden darf. Um eine Beschichtung von nicht zu beschichtenden Bereichen zu verhindern, werden im Stand der Technik noch häufig Maskierungstechniken, beispielsweise die Foto- oder Imprintlithographie, eingesetzt. Bei Fotoprozessen ist es allerdings üblich, zuerst eine gesamte Oberfläche des Wafers zu beschichten und anschließend zu strukturieren. Dieser Prozess bedingt daher wiederum eine vollständige Beschichtung der Oberfläche, die für manche Anwendungen unzulässig ist. Manche Anwendungen dürfen zu keinem Zeitpunkt mit dem Beschichtungsmaterial in Kontakt kommen. In anderen Anwendungen wäre ein kurzzeitiger Kontakt mit dem Beschichtungsmaterial zwar zulässig, allerdings stellt die Entfernung desselbigen von den Stellen, die nicht beschichtet werden sollen, ein großes Problem dar. So können beispielsweise Strukturen mit einem großen Höhe-zu-Breite Verhältnis einen sehr starken Kapillareffekt erzeugen, der die Entfernung des Beschichtungsmaterials aus den Strukturen unmöglich macht.
Des Weiteren sind alle Arten von Maskentechniken sind sehr kostspielig und aufwendig, insbesondere weil eine relativ große Anzahl von Prozessschritten ausgeführt werden muss. Eine steigende Anzahl von Prozessschritten erhöht nicht nur die Kosten, sondern auch die Fehleranfälligkeit.

Ein weiterer Ansatz in der Halbleiterindustrie ist das sogenannte Mikrokontaktprinten (µCP). Ein technisches Problem besteht darin, dass ein µCP-Stempel zur Übertragung eines Materials auf die Strukturen der zu beschichtenden Produktwafer angepasst werden muss. Für jede neue Art von Produktwafer muss ein neuer Stempel angefertigt werden. Des Weiteren besteht das Problem darin, dass ein µCP-Stempel in einem ersten Prozessschritt in das zu übertragende Material eingetaucht bzw. von seiner Rückseite mit dem Material getränkt werden muss. Danach erfolgt eine exakte Ausrichtung des µCP-Stempels relativ zu den erhabenen Strukturen des Produktwafers. In einem weiteren, dritten Prozessschritt erfolgt die Übertragung des Materials vom µCP-Stempel auf die zu beschichtenden Bereiche des Produktwafers.

Es ist daher die Aufgabe der vorliegenden Erfindung, ein Verfahren und eine Vorrichtung anzugeben, mit welchem die teilweise Beschichtung von Produktsubstraten mit möglichst wenigen, vorzugsweise einfachen, Prozessschritten auf kostengünstige Art und Weise bewerkstelligt werden kann. Das Verfahren und die Vorrichtung sollen möglichst universell einsetzbar sein und/oder einen möglichst hohen Durchsatz aufweisen. Diese Aufgabe wird insbesondere mit den Merkmalen der Ansprüche 1 und 6 gelöst. Vorteilhafte Weiterbildungen der Erfindung sind in den Unteransprüchen angegeben.

Der Erfindung liegt der Gedanke zugrunde, eine gattungsgemäße Vorrichtung beziehungsweise ein gattungsgemäßes Verfahren dadurch weiterzubilden, dass das auf einem Trägersubstrat aufgebrachte Beschichtungsmaterial, insbesondere durch Kontaktierung mit dem Produktsubstrat, nur teilweise auf das Produktsubstrat, insbesondere ausschließlich auf die zu beschichtenden Bereiche, übertragen wird. Dies wird insbesondere dadurch gelöst, dass beim Trennen des Trägersubstrats ein Teil des Beschichtungsmaterials auf dem Produktsubstrat verbleibt, und zwar insbesondere ausschließlich auf den zu beschichtenden Bereichen.

Die Erfindung handelt insbesondere davon, ein Trägersubstrat, in Form einer Trägerfolie, mit einem beliebigen Beschichtungsmaterial, insbesondere einem Polymer, noch bevorzugter BCB (Benzocyclobuten), zu beschichten und das Produktsubstrat, insbesondere einen Produktwafer, mit Erhöhungen als Stempel und gleichzeitig als Endprodukt zu verwenden. Dazu werden das Trägersubstrat und das Produktsubstrat miteinander kontaktiert und durch einen weiteren Prozessschritt, insbesondere einer Kraftübertragung durch eine Rolle, wird das Beschichtungsmaterial von dem Trägersubstrat auf die erhöhten Strukturen des Produktsubstrats übertragen. Das Produktsubstrat wirkt in diesem Prozessschritt also quasi als Stempel, ist gleichzeitig aber auch das zu beschichtende Produktsubstrat beziehungsweise das erfindungsgemäße Endprodukt.

Die Erfindung betrifft insbesondere eine Methode und eine Anlage, mit deren Hilfe topographische Produktsubstrate (also Substrate, die über erhöhte Strukturen verfügen) beschichtet werden können. Der Erfindung liegt dabei insbesondere der Gedanke zugrunde, die Beschichtung (oder das Beschichtungsmaterial) auf Erhebungsoberflächen der erhöhten Strukturen durch einen Schichtübertragungsprozess zu übertragen. Die Schicht wird vorher auf ein Trägersubstrat, in Form einer Trägerfolie, aufgebracht und das Trägersubstrat wird durch Aufbringen einer Kraft, insbesondere hervorgerufen durch eine sich bewegende Rolle, von dem Trägersubstrat, insbesondere zumindest überwiegend, vorzugsweise ausschließlich, auf die Erhebungsoberflächen übertragen.

Bei dem Beschichtungsmaterial handelt es sich vorzugsweise um ein Polymer, insbesondere um BCB. Das Polymer, insbesondere BCB, wird vorzugsweise zum Bonden der strukturierten Oberflächen zu einem zweiten Objekt, insbesondere einem zweiten Wafer, oder zu Verkapselungseinheiten benötigt.

Ein entscheidender Vorteil der erfindungsgemäßen Vorrichtung und des erfindungsgemäßen Verfahrens besteht insbesondere darin, dass einige Prozessschritte wegfallen beziehungsweise auf einige Prozessschritte verzichtet werden kann, die im Stand der Technik notwendig sind. Erfindungsgemäß kann insbesondere auf einen oder mehrere der nachfolgend genannten Prozessschritte verzichtet werden:
- Materialaufnahme auf einem, insbesondere vom Produktsubstrat unterschiedlichen, Stempel,
- Ausrichtungsprozesse, insbesondere mit einer Genauigkeit höher als 500 µm, vorzugsweise höher als 100 µm, noch bevorzugter höher als 1 µm, am bevorzugtesten höher als 50 nm, am allerbevorzugtesten höher als 1nm,
- Übertragungsprozesse von einem Stempel auf ein Produktsubstrat.

Die Herstellung der Materialschicht erfolgt erfindungsgemäß stattdessen bevorzugt auf einem Trägersubstrat, in Form einer Trägerfolie, und ist, insbesondere mittels einer Schleuderbelackungsanlage, auf einfachste Art und Weise zu realisieren. Der eigentliche Schichtübertragungsprozess findet dann direkt zwischen dieser Trägerfolie und dem Produktsubstrat statt und zwar insbesondere ohne einen einzigen Ausrichtungsschritt.

### Das Produktsubstrat

Die erfindungsgemäße Methode eignet sich für jede Art von Substrat, welches über Erhebungen verfügt, deren Erhebungsoberflächen beschichtet werden müssen. Die Beschichtung oder Belackung der Erhebungsoberflächen erfolgt dabei erfindungsgemäß insbesondere durch einen Schichtübertragungsprozess. Der Schichtübertragungsprozess verhindert insbesondere die Beschichtung oder Belackung der Oberflächen der zu den Erhebungen korrespondierenden Vertiefungen. Es werden zwei unterschiedliche Produktsubstrate beschrieben, für welche die erfindungsgemäße Methode besonders geeignet ist.

In einer ersten Ausführungsform besitzt das strukturierte Produktsubstrat eine mittlere Dicke t1 und mehrerer Erhebungen, welche funktionale Einheiten, in Form von Mikrosystemen wie MEMS (microelectromechanical systems), umgeben. Die Erhebungen dienen als Kavitätenwände, deren, insbesondere fluchtend beziehungsweise in einer Ebene verlaufende, Erhebungsoberflächen durch den erfindungsgemäßen Prozess beschichtet werden sollen. In dieser ersten Ausführungsform des Produktsubstrats werden die Kavitätenwände durch unterschiedliche Prozesse, insbesondere lithographische Prozesse an der Oberfläche des Produktsubstrats erzeugt.

In einer zweiten Ausführungsform besitzt das strukturierte Produktsubstrat eine mittlere Dicke t1' und mehrere Vertiefungen, in welchen die funktionalen Einheiten, in Form von Mikrosystemen wie MEMS, eingebettet sind. Die Vertiefungen werden bevorzugt direkt in das Produktsubstrat geätzt. Durch das Ätzen der Vertiefungen entstehen gleichzeitig die Kavitätenwände, welche die Vertiefungen umgeben.

### Das Trägersubstrat

Die Form der Trägersubstrate ist beliebig, wobei die Umfangskontur insbesondere rechteckig oder quadratisch ist. Die Seitenlängen derartiger rechteckiger Trägersubstrate sind insbesondere größer als 10 mm, vorzugsweise größer als 50 mm, noch bevorzugter größer als 200 mm, am bevorzugtesten größer als 300 mm. Insbesondere sind die Seitenlängen immer größer als die charakteristische geometrische Größe des Substrats. Die Umfangskontur der Trägersubstrate kann auch kreisrund sein. Der Durchmesser derartiger kreisrunder Trägersubstrate ist insbesondere industriell genormt. Die Trägersubstrate besitzen daher vorzugsweise einen Durchmesser von 1 Zoll, 2 Zoll, 3 Zoll, 4 Zoll, 5 Zoll, 6 Zoll, 8 Zoll, 12 Zoll und 18 Zoll. In besonderen Ausführungsformen kann es sich bei dem Trägersubstrat um eine, insbesondere aufgewickelte, Folie handeln, die in ein Laminiergerät gespannt werden kann. Es handelt sich dann quasi um eine "Endlosfolie".

Erfindungsgemäß ist das Trägersubstrat eine Trägerfolie. Die charakteristischste Eigenschaft der Trägerfolie ist ihre Biegsamkeit. Die Biegsamkeit wird am besten durch das (axiale) Widerstandsmoment angegeben. Unter der Annahme eines rechteckigen Querschnitts mit der Breite b und der Dicke t2 hängt das Widerstandmoment vom Quadrat der Dicke t2 ab. Je kleiner also die Dicke t2, desto kleiner das Widerstandmoment und desto geringer ist der (geometrische) Widerstand. Die erfindungsgemäßen Trägersubstrate besitzen insbesondere eine Dicke t2 kleiner als 1000 µm, vorzugsweise weniger als 500 µm, noch bevorzugter weniger als 100 µm, am bevorzugtesten weniger als 50 µm, am aller bevorzugtesten weniger als 10 µm. Die Trägerfolien können entweder auf einer flachen Unterlage, insbesondere auf dem Probenhalter, auf dem auch die Abscheidung des Materials erfolgt, fixiert werden oder flach aufliegen. Denkbar ist auch ein Aufspannen der Trägerfolie auf einen Rahmen.

In einer zweiten nicht erfindungsgemäßen Ausführungsform handelt es sich bei dem Trägersubstrat um einen Trägerwafer, insbesondere aus Silizium oder Glas. Der Trägerwafer ist vorzugsweise auf eine Dicke t2 gedünnt, bei der er sich biegen und formen lässt. Die erfindungsgemäßen Trägerwafer besitzen vorzugsweise eine Dicke t2 kleiner als 1000 µm, vorzugsweise weniger als 500 µm, noch bevorzugter weniger als 250 µm, am bevorzugtesten weniger als 100 µm, noch bevorzugter weniger als 50 µm. Derartige Trägersubstrate besitzen nicht die gleiche Flexibilität wie Trägerfolien, sind aber elastischer und können dadurch besser in ihre Ursprungsform zurückgeführt werden.

Das Trägersubstrat wird vor der Beschichtung oder Belackung mit dem zu übertragenden Beschichtungsmaterial erfindungsgemäß insbesondere so präpariert, dass sich das nach dem Schichtübertragungsprozess zurückbleibende Material möglichst leicht wieder von dem Trägersubstrat entfernen lässt, um das Trägersubstrat einem neuen Beschichtungsprozess zuzuführen. Insbesondere wird die Oberfläche des Trägersubstrats so modifiziert, dass die Adhäsion zwischen dem Material und der Trägersubstratoberfläche minimal wird. Die Adhäsion wird vorzugsweise über die Energie pro Flächeneinheit definiert, die notwendig ist, um zwei miteinander verbundene Oberflächen voneinander zu trennen. Die Energie wird dabei in J/m² angegeben. Die Energie pro Einheitsfläche, zwischen dem Trägersubstrat und dem Beschichtungsmaterial beträgt insbesondere weniger als 2.5 J/m², mit Vorzug weniger als 2.0 J/m², mit größerem Vorzug weniger als 1.5 J/m², mit größtem Vorzug weniger als 1.0 J/m², mit allergrößtem Vorzug weniger als 0.5 J/m², am bevorzugtesten weniger als 0.1 J/m².

Gemäß einer bevorzugten erfindungsgemäßen Ausführungsform ist die Adhäsion zwischen dem Beschichtungsmaterial und dem Trägersubstrat so gering, dass sich das Beschichtungsmaterial durch seine eigene Kohäsion wieder glättet (Selbstheilung bzw. Selbstglättung), so dass mehrere Abnahmen des Beschichtungsmaterials an mehreren Produktsubstraten möglich sind. Dadurch muss das Trägersubstrat zumindest nicht jedes Mal gereinigt und neu beschichtet werden. Dies kann insbesondere durch thermische und/oder elektrische und/oder magnetische Beanspruchung des Beschichtungsmaterials nach der Trennung unterstützt werden. Hierfür wird insbesondere die Viskosität erniedrigt, um bei einer genügend hohen Kohäsion zu einer Selbstglättung des Materials bei moderaten Temperaturen zu führen. Die Temperatur wird insbesondere kleiner als 500 °C, vorzugsweise kleiner als 250 °C, noch bevorzugter kleiner als 100 °C, am bevorzugtesten kleiner als 50 °C gewählt, noch bevorzugter findet eine Selbstglättung bei Raumtemperatur statt. Die Temperatur beträgt insbesondere mehr als 15°C.

### Der Prozess (Verfahren)

In einem ersten erfindungsgemäßen Prozessschritt wird ein wie oben beschrieben ausgebildetes Trägersubstrat für eine Beschichtung oder Belackung vorbereitet. Das Trägersubstrat wird auf einem Probenhalter fixiert. Der Probenhalter verfügt über Fixiermittel. Bei den Fixiermitteln kann es sich insbesondere um Vakuumbahnen, poröse, insbesondere aus Keramik gefertigte, mit Vakuum beaufschlagbare und einen Unterdruck aufbauende Elemente, mechanische Klemmen, elektrostatische Elemente, magnetische Elemente oder, insbesondere schaltbare, adhäsive Elemente handeln.

Soweit ein Vakuumprobenhalter verwendet wird, ist dieser bevorzugt so ausgebildet, dass genug Unterdruck erzeugbar ist, um eine starke Fixierung des Trägersubstrats von dem strukturierten Probenhalter zu gewährleisten. Der absolute Druck innerhalb des Vakuumprobenhalters ist insbesondere kleiner als 1 bar, vorzugsweise kleiner als 7.5^{∗}10⁻¹ mbar, noch bevorzugter kleiner als 5.0^{∗}10⁻¹ mbar, am bevorzugtesten kleiner als 2.5^{∗}10⁻¹ mbar, am allerbevorzugtesten kleiner als 1^{∗}10⁻¹ mbar. Der Probenhalter kann vorzugsweise geheizt und/oder gekühlt werden, insbesondere auf Temperaturen über 25°C, vorzugsweise über 50°C, noch bevorzugter über 100°C, am bevorzugtesten über 250°C, am aller bevorzugtesten über 500°C. Der Probenhalter kann kühlbar ausgebildet sein, beziehungsweise Kühlmittel aufweisen. Der Probenhalter kann insbesondere auf Temperaturen unter 25°C, vorzugsweise unter 0°C, noch bevorzugter unter -25°C, am bevorzugtesten unter -75°C, am allerbevorzugtesten unter -125°C. Eine entsprechende Kühlung eignet sich vor allem dann, wenn sich das zu übertragende Beschichtungsmaterial durch eine Kaltversprödung leichter vom Trägersubstrat löst. Die PCT/EP 2014/063687 beschreibt ein Verfahren, bei dem derartige Versprödungsmechanismen offenbart werden und auf die insofern Bezug genommen wird. Die Kühlvorrichtung des Probenhalters kann auch zur effizienteren, schnelleren und vor allem exakter gesteuerten Erniedrigung der erhöhten Temperatur des geheizten Probenhalters verwendet werden. Die Probenhalter können zur Fixierung des Trägersubstrats und/oder des strukturierten Probenhalters verwendet werden.

Das Trägersubstrat kann insbesondere mehrmals verwendet werden, insbesondere in Verbindung mit einer Reinigung vor einer erneuten Belackung oder Beschichtung. Die Reinigung erfolgt vorzugsweise mit einer dafür geeigneten Reinigungschemikalie. Die Reinigungschemikalie sollte vorzugsweise chemische Eigenschaften aufweisen, welche Reste des zu übertragenden Materials restlos entfernt, ohne das Trägersubstrat chemisch anzugreifen. Als Reinigungschemikalie wird/werden insbesondere eine oder mehrere der nachfolgenden gewählt:
- Wasser, insbesondere destilliertes Wasser und/oder
- Lösungsmittel, insbesondere limoninhaltige Lösungsmittel und/oder Aceton und/oder PGMEA und/oder Isopropanol und/oder Mesitylen und/oder
- Säuren und/oder
- Laugen.

Das Trägersubstrat kann, insbesondere zusätzlich, physikalisch durch Druckluft oder spezielle Reinigungsgase gereinigt werden, um Partikel zu entfernen.

Wurde die Oberfläche des Trägersubstrats entsprechend präpariert, sodass die Adhäsion zwischen dem Material und dem Trägersubstrat minimal ist, ist eine Reinigung umso einfacher. Vorzugsweise reicht dann bereits die Verwendung von destilliertem Wasser, um das Material und die Verunreinigungen wegzuspülen. Insbesondere wird eine Reinigungschemie gewählt, welche die Oberfläche nicht angreift.

In einem erfindungsgemäßen zweiten Prozessschritt erfolgt die Beschichtung oder Belackung des Trägersubstrats. Die Beschichtung oder Belackung des Trägersubstrats erfolgt vorzugsweise durch einen Schleuderbelackungsprozess. Denkbar wären auch Sprühbelackungsprozesse, Laminierprozesse und/oder Tauchprozesse. In ganz speziellen erfindungsgemäßen Ausführungsformen, insbesondere wenn das Trägersubstrat nur einmal verwendet wurde, können die Trägersubstrate bereits mit dem zu übertragenden Material beschichtet sein. Das ist vor allem bei Folien der Fall. Die Beschichtung der Folie kann dabei mittels Sprühbelackung, Schleuderbelackung, Extrusion, oder Tauchbeschichtung erfolgen.

Die Schichtdickenhomogenität nach der Beschichtung, insbesondere ein TTV-Wert (engl.: total thickness variation) des Beschichtungsmaterials ist insbesondere kleiner als 10 µm, vorzugsweise kleiner als 1 µm, noch bevorzugter kleiner als 100 nm, am bevorzugtesten kleiner als 10 nm, am allerbevorzugtesten kleiner als 1 nm. Die Schichtdickenhomogenität des zu übertragenden Materials wird durch den TTV Wert beschrieben. Darunter versteht man die Differenz zwischen der größten und der kleinsten gemessenen Schichtdicke auf der zu vermessenden Fläche (Beschichtungsfläche).

Erfindungsgemäß können alle Arten von Beschichtungsmaterialen für die Beschichtung oder Belackung verwendet werden. In einer bevorzugten Ausführungsform wird ein permanentes Bondingadhäsiv, insbesondere BCB, verwendet. Andere erfindungsgemäß denkbare Beschichtungsmaterialien sind:
- Polymere, insbesondere Bondingadhäsive, vorzugsweise
   □ temporäre Bondingadhäsive, noch bevorzugter HT10.10 und/oder
   □ permanente Bondingadhäsive, insbesondere Benzocyclobuten (BCB) und/oder JSR WPR 5100 und/oder SU-8 und/oder optische Kleber und/oder polyimid-basierte Kleber und/oder
- Metalle, insbesondere Au, Ag, Cu, Al, Fe, Ge, As, Sn, Zn, Pt und/oder W.

Erfindungsgemäß bevorzugt werden permanente Bondingadhäsive verwendet. Unter einem permanenten Bondingadhäsiv versteht man ein Polymer, welches zum permanenten Bonden verwendet wird. Das permanente Bonden erfolgt durch eine Vernetzung des Bondingadhäsivs, insbesondere durch Wärme und/oder elektromagnetische Strahlung, insbesondere UV Licht.

Das aufgetragene Beschichtungsmaterial wird nach der Beschichtung oder Belackung auf das Trägersubstrat vorzugsweise thermisch, behandelt, um Lösungsmittel auszutreiben. Die Temperatur zum Austreiben des Lösungsmittels ist insbesondere größer als 25°C, vorzugsweise größer als 50°C, noch bevorzugter größer als 75°C, am bevorzugtesten größer als 100°C, am allerbevorzugtesten größer als 125°C und/oder kleiner als 500°C, vorzugsweise kleiner als 250°C.

In einem erfindungsgemäßen dritten Prozessschritt erfolgt eine grobe Justierung der Trägerfolie relativ zum Produktsubstrat. Es ist ein entscheidender erfindungsgemäßer Vorteil, dass auf die Verwendung von Ausrichtungsanlagen oder einer Feinjustierung vollständig verzichtet werden kann. Das zu übertragende Material liegt vollflächig auf dem Trägersubstrat vor. Die zu beschichtenden Erhebungen des strukturierten Produktsubstrats kontaktieren bei Annäherung an das Trägersubstrat und damit an das Beschichtungsmaterial immer einen mit dem Beschichtungsmaterial beschichteten Bereich der Trägersubstratoberfläche. Das strukturierte Produktsubstrat wird damit zu einem mit Erhebungen versehenen Stempel.

Der Unterschied zwischen einer groben Justierung und einer Ausrichtung oder Feinjustierung liegt in der maximalen Ausrichtungsgenauigkeit der verwendeten Justiereinrichtung. Diese ist erfindungsgemäß insbesondere maximal 1 µm, vorzugsweise maximal 100 µm, noch bevorzugter maximal 500 µm, noch bevorzugter maximal 1 mm µm, am bevorzugtesten maximal 2 mm. Durch den erfindungsgemäßen Prozess kann also vorzugsweise eine Ausrichtung des Produktsubstrats relativ zum Trägersubstrat mit Hilfe eines Roboters oder, im Falle einer manuellen Handhabung, mit dem Auge erfolgen, ohne auf komplizierte technische Hilfsmittel wie Optiken oder Software zurückgreifen zu müssen.

In einem erfindungsgemäßen vierten Prozessschritt erfolgt eine, insbesondere gleichmäßige und sofortige, Kontaktierung zwischen dem Beschichtungsmaterial und der zu beschichtenden Erhebungsoberfläche durch Kontaktierungsmittel, insbesondere einer Laminiervorrichtung.

Gemäß einer ersten erfindungsgemäßen Ausführungsform wird eine Materialübertragung ausschließlich durch Kontakt der Oberfläche mit dem Beschichtungsmaterial bewirkt.

In einer weiteren erfindungsgemäßen Ausführungsform wird die Materialübertragung durch eine Kraft, insbesondere eine über das gesamte Trägersubstrat/Produktsubstrat aufgebrachte Flächenkraft, eine auf eine kleine Fläche des Trägersubstrats/Produktsubstrats konzentrierte Flächenkraft, eine Linienkraft oder eine Punktkraft, hervorgerufen oder zumindest beschleunigt. Die aufgebrachte Kraft ist insbesondere kleiner als 10 kN, vorzugsweise kleiner als 1000 N, noch bevorzugter kleiner als 100 N, am bevorzugtesten kleiner als 10 N, am allerbevorzugtesten kleiner als 1 N. Die Berechnung der auftretenden Drücke ergibt sich entsprechend durch die Division der Kraft durch die Fläche oder Linie. Entsprechend existieren Flächendruck und Liniendruck. Bei einer vollflächigen Belastung eines radialsymmetrischen, also kreisrunden, Produktsubstrats von ca. 200 mm Durchmesser, ergibt sich bei einer aufgebrachten, vollflächig lastenden Kraft von 10 kN ein Druck von ca. 31,8 kN/m² bzw. ca. 3,18 bar, für eine aufgebrachten, vollflächig lastenden Kraft von IN ein Druck von ca. 31,8 N/m² bzw. ca. 0,318 mbar. Der aufgebrachte Druck liegt daher vorzugsweise zwischen 4 bar und 0,3 mbar.

Gemäß einer weiteren Ausführungsform der Erfindung erfolgt die Krafteinwirkung über die Trägersubstrat- und/oder die Produktsubstratseite (insbesondere an der von der Kontaktierung abgewandten Seite) durch ein sich, insbesondere linear, fortbewegendes Kraftübertragungsmittel, insbesondere eine Rolle. Das Kraftübertragungsmittel wird insbesondere mit einer Vorschubgeschwindigkeit v von weniger als 100 mm/s, vorzugsweise weniger als 50 mm/s, noch bevorzugter weniger als 20 mm/s, am bevorzugtesten weniger als 10 mm/s, am allerbevorzugtesten weniger als 1.0 mm/s bewegt. Die Anpresskraft ist dabei insbesondere kleiner als 10 kN, vorzugsweise kleiner als 1000 N, noch bevorzugter kleiner als 100 N, am bevorzugtesten kleiner als 10 N, am allerbevorzugtesten kleiner als 1 N. Die Anpresskraft wirkt insbesondere entlang einer quer zur Vorschubbewegung verlaufenden Kontaktlinie L. Der Anpressdruck kann in N/mm angegeben werden. Bei einem angenommenen Träger- und Produktsubstratdurchmesser von 200 mm würde bei der oben genannten Kraft in einer Position in der Mitte der beiden Substrate ein Anpressliniendruck von weniger als 50 kN/m, vorzugsweise weniger als 5000 N/m, noch bevorzugter weniger als 500 N/m, am bevorzugtesten weniger als 50 N/m am allerbevorzugtesten weniger als 5 N/m ergeben. Eine Vorrichtung die zur Durchführung des erfindungsgemäßen Prozesses geeignet wäre, ist in der Druckschrift WO2014/037044A1 offenbart, auf die insofern Bezug genommen wird.

Die Temperatur während der Krafteinwirkung ist kleiner als 500°C, vorzugsweise kleiner als 300°C, noch bevorzugter kleiner als 150°C, am bevorzugtesten kleiner als 50°C, am allerbevorzugtesten, insbesondere ohne Heizen oder Kühlen, Raumtemperatur. Im Falle der erfindungsgemäßen Beschichtung mit Polymeren liegt die Temperatur während der Krafteinwirkung vorzugsweise oberhalb der Glasübergangstemperatur des Polymers.

Die aufzubringende Kraft oder der aufzubringende Druck wird vorzugsweise so gewählt, dass das Trägersubstrat sich nicht nennenswert durchbiegt und das Beschichtungsmaterial nicht in den Vertiefungen, sondern nur auf den Erhebungsoberflächen, abgeschieden wird.

Die Kontaktzeit ist insbesondere kleiner als 60 s, vorzugsweise kleiner als 30 s, noch bevorzugter kleiner als 25 s, am bevorzugtesten kleiner als 10 s, am allerbevorzugtesten kleiner als 2 s. Bei der Anwendung einer auf eine kleine Fläche konzentrierte Flächenkraft, eine Linienkraft oder eine Punktkraft versteht man unter der Kontaktzeit die Verweilzeit des Kraftübertragungsmittel auf die kleine Fläche, die Linie oder den Punkt. In einem erfindungsgemäßen weiteren Prozessschritt erfolgt die Trennung des strukturierten Produktsubstrats vom Trägersubstrat durch Trennungsmittel, insbesondere eine Delaminiervorrichtung.

Gemäß einer ersten, erfindungsgemäßen Variante erfolgt die Trennung durch Abziehen oder Delaminieren des Trägersubstrats vom strukturierten Produktsubstrat. Eine Delamination durch Abziehen ist besonderes dann möglich und sinnvoll, wenn es sich bei dem Trägersubstrat um eine Trägerfolie handelt, die durch eine Krafteinwirkung zu stark an den Oberflächen der Erhebungen des strukturierten Produktsubstrats haftet. Dadurch wird ein partielles, schrittweises Trennen der Trägerfolie vom strukturierten Produktsubstrat, genauer von den Oberflächen der Erhebungen, ermöglicht.

Gemäß einer zweiten, nicht erfindungsgemäßen Variante des Trennverfahrens erfolgt die Trennung durch eine einfache relative Entfernung (insbesondere ohne Verformung) des Trägersubstrats von dem strukturierten Produktsubstrat (oder umgekehrt). Für eine derartige Entfernung werden Normalkräfte, insbesondere Normalflächenkräfte, angelegt, welche vorzugsweise so angelegt sind, dass sich weder das Trägersubstrat noch das strukturierte Produktsubstrat beim Abheben verformen. Daher werden beide Substrate vorzugsweise vollflächig auf einem entsprechenden Probenhalter, insbesondere einem Vakuumprobenhalter fixiert.

Die Temperatur während der Trennung ist insbesondere kleiner als 500°C, vorzugsweise kleiner als 300°C, noch bevorzugter kleiner als 150°C, am bevorzugtesten kleiner als 50°C, am allerbevorzugtesten Raumtemperatur, insbesondere ohne Heizen oder Kühlen. Im Falle der erfindungsgemäßen Beschichtung mit Polymeren liegt die Temperatur während der Trennung vorzugsweise unterhalb der Glasübergangstemperatur des Polymers.

Nach der Trennung verbleibt das Beschichtungsmaterial zumindest teilweise, vorzugsweise überwiegend an den Oberflächenerhebungen des Produktsubstrats.

In einem weiteren, erfindungsgemäßen Prozessschritt kann dann eine Verkapselung erfolgen. Eine Abdeckung, insbesondere ein weiteres Substrat (insbesondere ein Wafer) wird durch entsprechende Vorrichtungen, insbesondere Waferbonder oder Chip-to-Wafer-Bonder, auf das Beschichtungsmaterial gepresst. Nach dem Bondvorgang kann noch ein Aushärteprozess des Beschichtungsmaterials erfolgen. Bei dem Aushärteprozess handelt es sich vorzugsweise um einen thermischen und/oder elektromagnetischen Aushärteprozess. Bei einer thermischen Aushärtung ist die Temperatur insbesondere größer als 50°C, vorzugsweise größer als 100°C, noch bevorzugter größer als 150°C, am bevorzugtesten größer als 200°C, am allerbevorzugtesten größer als 250°C. Im Falle einer Aushärtung durch elektromagnetische Strahlung, insbesondere durch UV-Licht, besitzt die elektromagnetische Strahlung insbesondere eine Wellenlänge im Bereich zwischen 10nm und 2000nm, mit Vorzug zwischen 10nm und 1500nm, mit größerem Vorzug zwischen 10nm und 1000nm, mit allergrößtem Vorzug zwischen 10nm und 500nm, mit allergrößtem Vorzug zwischen 10nm und 400nm.

### Anlage (Vorrichtung)

In einer ersten erfindungsgemäßen Ausführungsform besteht eine erfindungsgemäße Anlage aus mindestens
- einer weiteren Vorrichtung oder einem weiteren Modul zum Kontaktieren des Trägersubstrats mit dem strukturierten Produktsubstrat, insbesondere zur Beanspruchung des Trägersubstrats mit einer Rolle, noch bevorzugter einem Laminiergerät zum Laminieren der Folie und
- einer Vorrichtung oder einem Modul zum Entfernen des Trägersubstrats vom strukturierten Produktsubstrat, insbesondere einem Delaminiergerät.

Optional wäre für die erfindungsgemäße Ausführungsform noch eine Vorrichtung oder einem Modul zur Beschichtung oder Belackung des Trägersubstrats, insbesondere einer Schleuderbelackungsvorrichtung, vorgesehen. Auf derartige Module kann allerdings in der erfindungsgemäße Ausführungsform verzichtet werden, sofern die Trägersubstrate bereits vorher, von anderen Vorrichtungen oder Anlagen, beschichtet werden.

Die drei genannten Vorrichtungen können Teile eines einzelnen Moduls oder separate zueinander kompatible Module sein, welche in weiterer Folge entweder einzeln oder als Teil eines Clusters verwendet werden können. Denkbar ist auch, dass jede der drei genannten Vorrichtungen in jeweils einem separaten Modul vorhanden ist und der erfindungsgemäße Prozess entlang der Prozesskette der Module durchgeführt wird.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in:
- Figur 1a: eine schematische, nicht maßstabsgetreue Seitenansicht einer ersten Ausführungsform eines erfindungsgemäß strukturierten Produktsubstrats,
- Figur 1b: eine schematische, nicht maßstabsgetreue Seitenansicht einer zweiten Ausführungsform des strukturierten Produktsubstrats,
- Figur 2a bis 2g: schematische, nicht maßstabsgetreue Seitenansichten von Prozessschritten einer Ausführungsform eines erfindungsgemäßen Verfahrens,
- Figur 3a: eine schematische, nicht maßstabsgetreue Seitenansicht eines ersten Endprodukts (Verpackung funktionaler Einheiten),
- Figur 3b: eine schematische, nicht maßstabsgetreue Seitenansicht eines zweiten Endprodukts (Verpackung funktionaler Einheiten) und
- Figur 4: eine schematische Skizze einer Ausführungsform einer erfindungsgemäßen Vorrichtung.

In den Figuren sind gleiche Bauteile und Bauteile mit der gleichen Funktion oder Bauteile in unterschiedlichen Bearbeitungszuständen mit den gleichen Bezugszeichen gekennzeichnet.

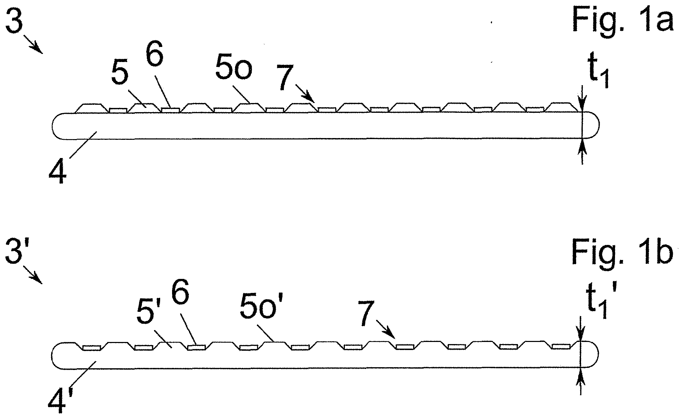

Die Figur 1a zeigt eine schematische, nicht maßstabgetreue Seitenansicht eines Produktsubstrats 3, bestehend aus:
- einem Wafer 4, auf dem mehrere Erhebungen 5 ausgebildet sind,
- zwischen den Erhebungen 5 sind funktionale Einheiten 6 angeordnet, die verkapselt werden sollen.

Der Wafer 4 besitzt eine mittlere Dicke t1. Die gesamte Dicke des strukturierten Produktsubstrats 3 ist dementsprechend größer als t1.

Die Figur 1b zeigt einen schematische, nicht maßstabgetreue Seitenansicht eines strukturierten Produktsubstrats 3', bestehend aus:
- einem, insbesondere durch Ätzung erzeugten, Wafer 4' mit mehreren Erhebungen 5, die durch das Ätzen von Vertiefungen 7 entstanden sind,
- zwischen den Erhebungen 5, also in den Vertiefungen 7, sind die funktionalen Einheiten 6 angeordnet, die verkapselt werden sollen.

Der Wafer 4' besitzt eine mittlere Dicke t1'. Die gesamte Dicke des strukturierten Produktsubstrats 3' ist bei dieser Ausführungsform insbesondere gleich der Dicke t1'.

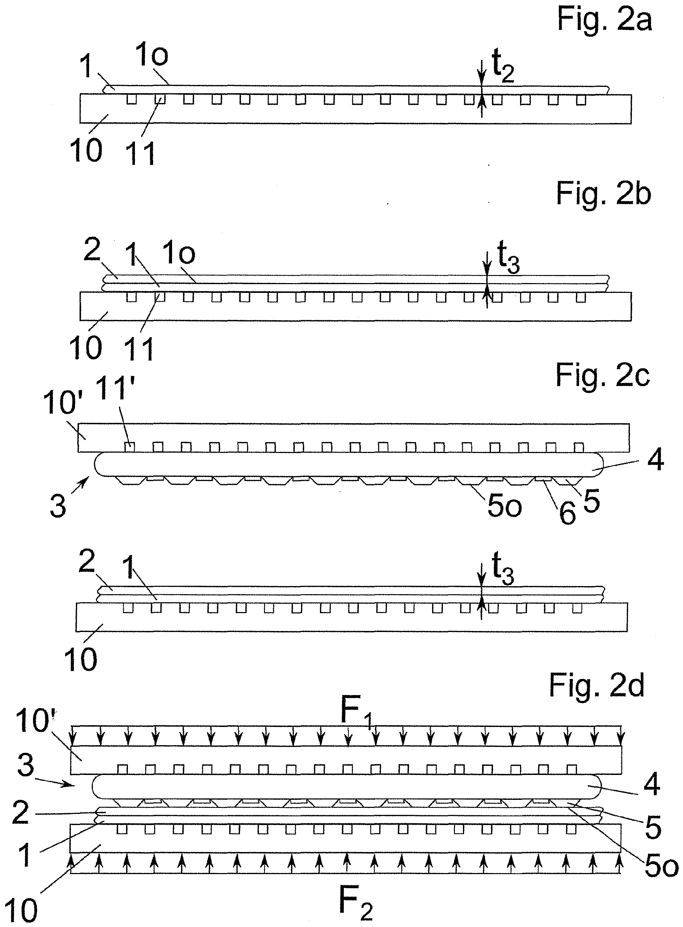

In der Figur 2a wird der erste erfindungsgemäße Prozessschritt der Trägersubstratvorbereitung dargestellt. Dabei wird ein Trägersubstrat 1 mit einer von einer Trägersubstratoberfläche 1o abgewandten Seite auf einem Probenhalter 10 abgelegt bzw. fixiert. Die Fixierung erfolgt durch Fixiermittel 11, insbesondere Vakuumbahnen, an denen ein Vakuum angelegt werden kann. Denkbar sind auch elektrostatische, elektrische, adhäsive, magnetische oder mechanische Fixierungen, die dafür sorgen, dass das Trägersubstrat 1 relativ zum Probenhalter 10 fixiert wird und fixiert bleibt.

Das Trägersubstrat 1 ist erfindungsgemäß eine Trägerfolie. Im ersten Prozessschritt kann eine Reinigung der Trägersubstratoberfläche 1o erfolgen. Das ist vor allem dann notwendig, wenn die Trägersubstratoberfläche 1o bereits in einem vorhergehenden Prozessschritt mit einem Beschichtungsmaterial 2 beschichtet wurde und nun wiederverwendet werden soll.

Die Figur 2b zeigt einen erfindungsgemäßen zweiten Prozessschritt, bei dem ein Beschichtungsmaterial 2 auf der Trägersubstratoberfläche 1o abgeschieden wird. Die Abscheidung erfolgt vorzugsweise in einer Schleuderbelackungsanlage, alternativ in einer Sprühbelackungsanlage. Eine Materialschichtdicke t3 kann sehr präzise eingestellt werden und liegt vorzugsweise im Mikro- bzw. noch bevorzugter im Nanometerbereich.

In einem erfindungsgemäßen dritten Prozessschritt gemäß Figur 2c erfolgt eine grobe Justierung des strukturierten Produktsubstrats 3, bestehend aus dem Wafer 4 mit Erhöhungen 5 in Relation zu dem mit dem Beschichtungsmaterial 2 präparierten, Trägersubstrat 1. Das strukturierte Produktsubstrat 3 wird dabei ebenfalls von einem Probenhalter 10' durch Fixiermittel 11' fixiert. Eine genaue Justierung des strukturierten Probenhalters 3 in Bezug zum Trägersubstrat 1 ist nicht notwendig, da Erhebungsoberflächen 5o der Erhebungen 5 sich an jeder Position über einem Teil des Beschichtungsmaterials 2 befinden und bei nachfolgender Kontaktierung mit diesem in Kontakt kommen.

In den weiteren Figuren wird das Trägersubstrat 1 auf seinem Probenhalter 10 immer an der Unterseite dargestellt, obwohl in der Umsetzung des erfindungsgemäßen Prozesses ein Ablegen bzw. Laminieren des Trägersubstrats 1, in Form einer Trägerfolie, auf dem strukturierten Produktsubstrat 3 vorzuziehen ist. Des Weiteren wird offenbart, dass der Probenhalter 10, der das Trägersubstrat 1 fixiert, insbesondere eine Fixiereinrichtung eines Laminiergeräts ist, welche das Trägersubstrat 1, in Form einer Trägerfolie, fixiert, insbesondere spannt, sodass sie auf das zu beschichtende strukturierte Produktsubstrat 3 laminiert werden kann. Somit wird das Trägersubstrat 1 nicht vollflächig gestützt.

In einem erfindungsgemäßen vierten Prozessschritt gemäß Figur 2d erfolgt eine Kontaktierung der Erhebungsoberflächen 5o mit dem Beschichtungsmaterial 2. In diesem Prozessschritt kann das strukturierte Produktsubstrat 3 als eine Art Stempel angesehen werden. Die Übertragung des Beschichtungsmaterials 2 auf die Erhebungsoberflächen 5o wird vorzugsweise durch eine Kraft, insbesondere eine Flächenkraft F, begünstigt, verstärkt oder sogar erst ermöglicht.

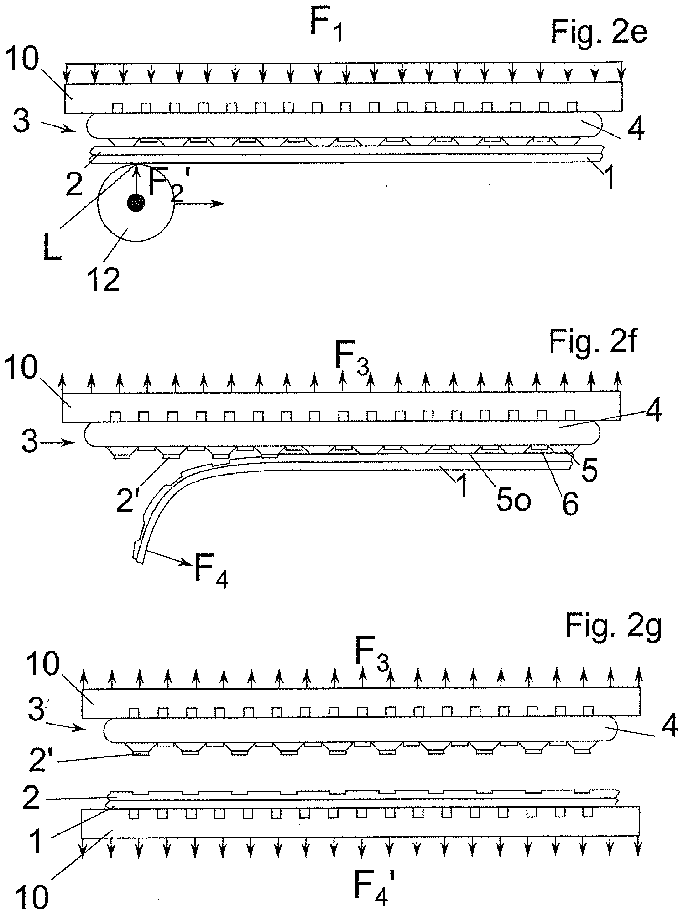

In einem speziellen, insbesondere alternativen oder zusätzlichen, erfindungsgemäßen Prozessschritt gemäß Figur 2e erfolgt eine optimalere Materialübertragung durch die Anwendung eines sich bewegenden Kraftübertragungsmittels 12, insbesondere einer Rolle. Das Kraftübertragungsmittel 12 übt dabei eine Kraft F, insbesondere eine Linienkraft, auf eine Rückseite des Trägersubstrats 1, in Form einer Trägerfolie, aus und begünstigt so die Materialübertragung von dem Trägersubstrat 1 auf die Erhebungsoberflächen 5o. Der erfindungsgemäße Prozessschritt gemäß Figur 2e kann mit dem erfindungsgemäßen Prozessschritt gemäß Figur 2d kombiniert werden, sofern der Probenhalter 10, der das Trägersubstrat 1 fixiert, elastisch genug ist, um die Kraftübertragung des Kraftübertragungsmittel 12 zu erlauben.

In einem erfindungsgemäßen ersten Trennungsschritt gemäß Figur 2f wird das Trägersubstrat 1, in Form einer Trägerfolie, von den Erhebungsoberflächen 5o abgezogen. Das Abziehen beginnt von einer oder mehreren, insbesondere peripher gelegenen Stellen. Das Abziehen ist daher insbesondere nicht vollflächig.

In einem nicht erfindungsgemäßen zweiten, alternativen Trennungsschritt gemäß Figur 2g werden das Trägersubstrat 1 und das strukturierte Produktsubstrat 3 durch Normalkräfte, insbesondere Flächenkräfte, voneinander entfernt.

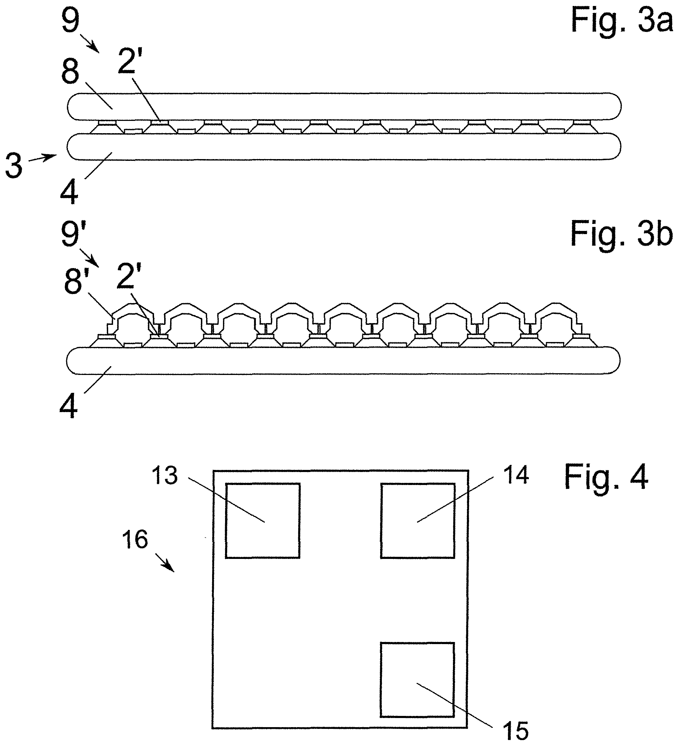

Die Figuren 3a und 3b zeigen zwei Verkapselungsmöglichkeiten der strukturierten Produktsubstrate 3, 3' in Endprodukte 9, 9' (Verpackung funktionaler Einheiten).

Bei der Ausführungsform gemäß Figur 3a erfolgt die Verkapselung durch das Bonden einer Abdeckung 8 in Form eines Wafers auf das erfindungsgemäß übertragene Beschichtungsmaterial 2'.

Bei der Ausführungsform gemäß Figur 3b wird ein Endprodukt 9' gezeigt, bei dem die Verkapselung durch einzelne Abdeckungen 8' erfolgt. Die einzelnen Abdeckungen 8' können beispielsweise durch einen Chip-to-Wafer Bonder positioniert und gebondet werden.

Die Figur 4 zeigt eine schematische Skizze einer erfindungsgemäßen Anlage 16, die aus einer Beschichtungsvorrichtung 13, einer Laminiervorrichtung 14 (Kontaktierungsmittel) und einer Delaminiervorrichtung 15 (Trennungsmittel) besteht. Unter einer Laminiervorrichtung 14 versteht man in diesem Zusammenhang jede Vorrichtung, die in der Lage ist, eine erfindungsgemäße Schichtübertragung des Beschichtungsmaterials 2, 2' von einem Trägersubstrat 1 auf die Erhebungsoberflächen 5o durchzuführen. Insbesondere versteht man darunter eine klassische Laminiervorrichtung. Denkbar wäre allerding auch die Verwendung eines Bonders, insbesondere eines Waferbonders, der das Trägersubstrat 1 durch Annäherung an das strukturierte Produktsubstrat 3 heranführt.

Unter einer Delaminiervorrichtung 15 versteht man in diesem Zusammenhang jede Vorrichtung, die in der Lage ist, eine erfindungsgemäße Entfernung des Trägersubstrats 2 vom strukturierten Produktsubstrat 3, insbesondere den Erhebungsoberflächen 5o durchzuführen. Insbesondere versteht man darunter einen klassischen Delaminierer.

Einige Laminiervorrichtungen 14 können gleichzeitig auch als Delaminiervorrichtungen 15 verwendet werden.

Ein Robotersystem, Waferkassetten, insbesondere Foups oder alle anderen notwendigen Bauteile, die zur Hantierung, Manipulation, zum Laden oder Entladen der notwendigen Substrate benötigt werden, sind nicht dargestellt.

### Verfahren und Vorrichtung zum Beschichten eines Produktsubstrats

### Bezugszeichenliste

- 1: Trägersubstrat
- 2, 2': Beschichtungsmaterial
- 3, 3': Produktsubstrat
- 4, 4': Wafer
- 5, 5': Erhebungen
- 5o, 5o': Erhebungsoberflächen
- 6: Funktionale Einheiten
- 7: Vertiefungen
- 8, 8': Abdeckung
- 9: Endprodukt
- 10, 10': Probenhalter
- 11, 11': Fixiermittel
- 12: Kraftübertragungsmittel
- 13: Beschichtungsvorrichtung
- 14: Laminiervorrichtung
- 15: Delaminiervorrichtung
- 16: Anlage

## Patentansprüche

1. Verfahren zur Beschichtung einer Erhebungsoberfläche (5o, 5o') von, insbesondere diskreten, Erhebungen (5, 5') eines zumindest teilweise, vorzugsweise überwiegend, in Vertiefungen (7) angeordnete funktionale Einheiten (6) aufweisenden Produktsubstrats (3, 3'), **dadurch gekennzeichnet, dass** die funktionalen Einheiten (6) Mikrosysteme sind, und mit folgenden Schritten, insbesondere folgendem Ablauf:
- Kontaktierung der Erhebungsoberfläche (5o, 5o') mit einem auf einer flexiblen Trägerfolie (1) aufgebrachten Beschichtungsmaterial (2, 2'),
- Trennung der Folie (1) von der Erhebungsoberfläche (5o, 5o') derart, dass das Beschichtungsmaterial (2, 2') teilweise auf dem Produktsubstrat (3, 3') verbleibt, wobei die Folie (1) partiell und schrittweise von den Erhebungsoberflächen (5o, 5o') getrennt wird.

2. Verfahren nach Anspruch 1,
**dadurch gekennzeichnet, dass** das auf dem Produktsubstrat (3, 3') verbleibende Beschichtungsmaterial (2, 2') zumindest überwiegend, vorzugsweise ausschließlich, auf der Erhebungsoberfläche (5o, 5o') verbleibt.

3. Verfahren nach einem der Ansprüche 1 oder 2,
**dadurch gekennzeichnet, dass** die funktionalen Einheiten (6) zumindest an in den Vertiefungen liegenden Abschnitten nicht mit dem Beschichtungsmaterial (2, 2') beaufschlagt werden.

4. Verfahren nach einem der vorhergehenden Ansprüche,
**dadurch gekennzeichnet, dass** während der Kontaktierung eine Kraftbeaufschlagung zur Fixierung des Beschichtungsmaterials (2,2') an der Erhebungsoberfläche (5o,5o') mittels einer ersten Kraft F₁ und einer zweiten, der ersten Kraft F₁ entgegengesetzten Kraft F₂/F₂' erfolgt.

5. Verfahren nach einem der vorhergehenden Ansprüche,
**dadurch gekennzeichnet, dass** nach der Trennung eine Verkapselung der funktionalen Einheiten (6) durch Bonden mindestens einer Abdeckung (8, 8') auf die Erhebungsoberfläche (5o, 5o') vermittels des Beschichtungsmaterials (2, 2') erfolgt.

6. Vorrichtung zum Beschichten einer Erhebungsoberfläche (5o, 5o') von, insbesondere diskreten, Erhebungen (5, 5') eines zumindest teilweise, vorzugsweise überwiegend, in Vertiefungen (7) angeordnete funktionale Einheiten (6) aufweisenden Produktsubstrats (3, 3'), **dadurch gekennzeichnet, dass** die funktionalen Einheiten (6) Mikrosysteme sind, mit
- Kontaktierungsmitteln zur Kontaktierung der Erhebungsoberfläche (5o, 5o') mit einem auf einer flexiblen Trägerfolie (1) aufgebrachten Beschichtungsmaterial (2, 2'),
- Trennungsmitteln zur Trennung der Folie (1) von der Erhebungsoberfläche (5o, 5o') derart, dass das Beschichtungsmaterial (2, 2') teilweise auf dem Produktsubstrat (3, 3') verbleibt, wobei die Folie (1) partiell und schrittweise von den Erhebungsoberflächen (5o, 5o') trennbar ist.

## Claims

1. A method for coating a projecting surface (5o, 5o') of, in particular discrete, projections (5, 5') of a product substrate (3, 3') that has functional units (6) arranged at least partially, preferably predominantly, in recesses (7),
**characterised in that** the functional units (6) are microsystems, and with the following steps, in particular the following sequence:
- Bringing the projecting surface (5o, 5o') into contact with a coating material (2, 2') that is applied on a flexible carrier film (1),
- Separating the film (1) from the projecting surface (5o, 5o') in such a way that the coating material (2, 2') remains partially on the product substrate (3, 3'), wherein the film (1) is separated partially and gradually from the projecting surfaces (5o, 5o').

2. The method according to claim 1,
**characterised in that** the coating material (2, 2') that remains on the product substrate (3, 3') remains at least predominantly, preferably exclusively, on the projecting surface (5o, 5o').

3. The method according to any one of claims 1 or 2,
**characterised in that** the functional units (6) are not exposed to the coating material (2, 2') at least on the sections that lie in the recesses.

4. The method according to any one of the preceding claims,
**characterised in that**, during the contacting, an application of force takes place for the fixing of the coating material (2, 2') to the projecting surface (5o, 5o') by means of a first force F₁ and a second force F₂/F₂' that is opposite the first force F₁.

5. The method according to any one of the preceding claims,
**characterised in that**, after the separation, an encapsulation of the functional units (6) takes place by bonding at least one cover (8, 8') to the projecting surface (5o, 5o') by means of the coating material (2, 2').

6. A device for coating a projecting surface (5o, 5o') of, in particular discrete, projections (5, 5') of a product substrate (3, 3') that has functional units (6) arranged at least partially, preferably predominantly, in recesses (7),
**characterised in that** the functional units (6) are microsystems, with
- contacting means for bringing the projecting surface (5o, 5o') into contact with a coating material (2, 2') that is applied on a flexible carrier film (1),
- separating means for separating the film (1) from the projecting surface (5o, 5o') in such a way that the coating material (2, 2') remains partially on the product substrate (3, 3'), wherein the film (1) can be separated partially and gradually from the projecting surfaces (5o, 5o').

## Revendications

1. Procédé destiné à revêtir une surface d'élévations (5o, 5o') d'élévations (5, 5'), en particulier discrètes, d'un substrat de produit (3, 3') présentant au moins partiellement, de préférence principalement, des unités (6) fonctionnelles disposées dans des creux (7),
**caractérisé en ce que** les unités fonctionnelles (6) sont des microsystèmes, et comprenant les étapes suivantes, en particulier le déroulement suivant :
- mise en contact de la surface d'élévations (5o, 5o') avec un matériau de revêtement (2, 2') placé sur un film porteur (1) flexible,
- séparation du film (1) de la surface d'élévations (5o, 5o') de telle façon que le matériau de revêtement (2, 2') reste partiellement sur le substrat de produit (3, 3'), dans lequel le film (1) est séparé des surfaces d'élévations (5o, 5o'), partiellement et par étapes.

2. Procédé selon la revendication 1,
**caractérisé en ce que** le matériau de revêtement (2, 2') restant sur le substrat de produit (3, 3') reste, au moins principalement, de préférence exclusivement, sur la surface d'élévations (5o, 5o').

3. Procédé selon l'une des revendications 1 ou 2,
**caractérisé en ce que** les unités (6) fonctionnelles ne reçoivent pas le matériau de revêtement (2, 2'), au moins sur des tronçons reposant dans les creux.

4. Procédé selon l'une des revendications précédentes,
**caractérisé en ce que** pendant la mise en contact, il se produit un apport de force pour fixer le matériau de revêtement (2, 2') à la surface d'élévations (5o, 5o') au moyen d'une première force F₁ et d'une deuxième force F₂/F₂' opposée à la première force F₁.

5. Procédé selon l'une des revendications précédentes,
**caractérisé en ce qu'**après la séparation, il y a encapsulage des unités (6) fonctionnelles par liaison d'au moins un recouvrement (8, 8') sur la surface d'élévations (5o, 5o') au moyen du matériau de revêtement (2, 2').

6. Dispositif destiné à revêtir une surface d'élévations (5o, 5o') d'élévations (5, 5'), en particulier discrètes, d'un substrat de produit (3, 3') présentant au moins partiellement, de préférence principalement, des unités (6) fonctionnelles disposées dans des creux (7),
**caractérisé en ce que** les unités fonctionnelles (6) sont des microsystèmes, comprenant :
- des moyens de mise en contact pour mettre en contact la surface d'élévations (5o, 5o') avec un matériau de revêtement (2, 2') placé sur un film porteur (1) flexible,
- des moyens de séparation pour séparer le film (1) de la surface d'élévations (5o, 5o') de telle façon que le matériau de revêtement (2, 2') reste partiellement sur le substrat de produit (3, 3'), dans lequel le film (1) peut être séparé des surfaces d'élévations (5o, 5o'), partiellement et par étapes.
